# FASCICULE DE BREVET EUROPEEN

(11) **EP 0 512 878 B1**
(45) Date de publication et mention de la délivrance du brevet: **14.08.1996**
(21) Numéro de dépôt: 92401115.8
(22) Date de dépôt: 21.04.1992
(51) Int. Cl.: H04N 3/15, H01L 27/148

(54) **Dispositif photosensible à registres de lecture juxtaposés**
Lichtempfindliche Vorrichtung mit nebeneinanderliegenden Leseregistern
Photosensitive device with read registers placed side by side

(30) Priorité: 03.05.1991 FR 9105470
(43) Date de publication de la demande: 11.11.1992
(73) Titulaire: THOMSON-CSF SEMICONDUCTEURS SPECIFIQUES, 75008 Paris (FR)
(72) Inventeur: Cazaux, Yvon, F-92045 Paris la Défense (FR); Brissot, Louis, F-92045 Paris la Défense (FR); Gili, Bruno, F-92045 Paris la Défense (FR)
(74) Mandataire: Guérin, Michel

(56) Documents cités:
- US-A- 4 949 183
- L'ONDE ELECTRIQUE, vol. 70, no. 3, mai/juin 1990, pages 51-54, Paris, FR; D. HERAULT et al.: "Photocapteur matriciel à transfert de charges pour caméras de studio TVHD"
- PATENT ABSTRACTS OF JAPAN, vol. 12, no. 211 (E-622)[3058], 16 juin 1988; & JP-A-63 9153
- 1990 IEEE INTERNATIONAL SOLID-STATE CIRCUITS CONFERENCE, DIGEST OF TECHNICAL PAPERS (ISSCC'90), San Francisco, 14-16 février 1990, pages 214-215,299; K. YONEMOTO et al.: "Image sensor, processors and displays"

## Description

L'invention concerne les dispositifs semiconducteurs à transfert de charge, notamment les dispositifs utilisés pour réaliser des capteurs d'image. Elle concerne particulièrement le cas où ces dispositifs comportent des pixels disposés en ligne avec un pas faible.

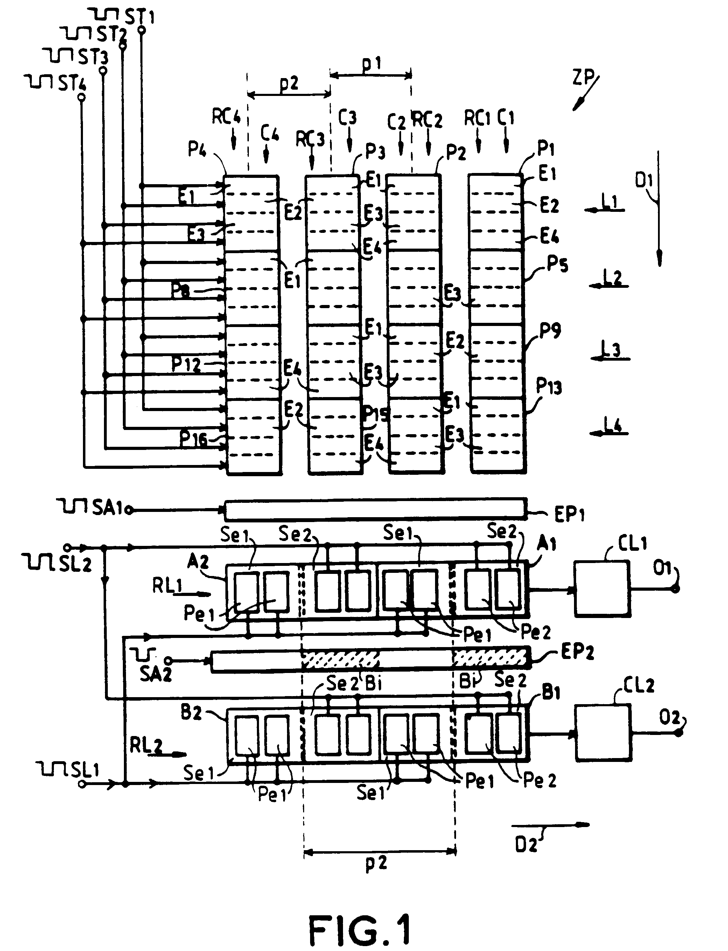

La figure 1 montre schématiquement une architecture classique d'un dispositif à transfert de charge (en anglais "Charges Coupled Device" ou en abrégé CCD) organisée pour constituer un détecteur d'image surfacique. Ces dispositifs sont en général fabriqués sur un substrat de silicium de type P par exemple sur lequel on fait croître une couche épitaxiale de même type. Des électrodes E1 à E4 isolées par une couche isolante mince sont déposées sur la surface du substrat. L'éclairement du silicium dans une zone photosensible ZP engendre des charges par effet photoélectrique. La zone photosensible ZP est partagée en une pluralité de surfaces élémentaires photosensibles ou pixels P1 à P16.

Ces pixels P1 à P16 sont disposés en lignes et en colonnes et dans l'exemple de la figure 1 et pour simplifier cette dernière, seulement quatre lignes L1 à L4 et quatre colonnes C1 à C4 de pixels ont été représentées, mais bien entendu le détecteur d'image peut comporter un nombre plus important de lignes et de colonnes où même un nombre plus faible.

Dans le sens des colonnes C1 à C4, les successions de pixels constituent des registres à décalage CCD dont chaque étage est constitué par un pixel P1 à P16. Dans la suite de la description on appelle ces registres "registres colonnes RC1 à RC4". Chaque registre colonne permet ainsi de transférer suivant un sens de transfert D1, les charges produites dans la colonne C1 à C4 correspondante. A cet effet, les électrodes E1 à E4 de tous les pixels P1 à P16 sont commandées par une succession de potentiels propres à provoquer sous ces électrodes, une alternance de puits et de barrières de potentiel appropriés à produire le transfert. Ceci est obtenu en appliquant aux électrodes E1 à E4 des signaux de transfert constitués par des créneaux de tension ST1 à ST4 ayant des phases différentes.

Le transfert des charges peut s'effectuer en mode biphasé, ou en trois phases, quatre phases ou davantage. Dans l'exemple représenté ce transfert est effectué suivant le mode quatre phases. A cet effet chaque étage ou pixel P1 à P16 est partagé en quatre sous étages, c'est-à-dire que chaque étage comporte quatre électrodes E1, E2, E3, E4 qui se succèdent dans le sens des colonnes C1 à C4, et qui reçoivent chacune un signal de transfert ayant une phase différente par rapport à la phase du signal reçu par les autres électrodes du même étage. Ainsi en mode trois phases, chaque étage ou pixel P1 à P16 comporte trois électrodes recevant chacune un signal de transfert différent ; et en mode biphasé chaque étage comprend deux couples d'électrodes, les deux électrodes d'un même couple étant reliées et commandées par un même signal de transfert.

Les charges produites dans chaque pixel ou étage P1 à P16 doivent être acheminées jusque dans un circuit de lecture CL1, CL2, dont une sortie 01, 02 délivre un signal de tension proportionnel à la valeur de la charge lue. A cette fin, les charges sont transférées une première fois dans le sens de transfert D1 parallèlement aux colonnes C1 à C4 ; puis les charges sont transférées une seconde fois suivant un second sens de transfert D2 perpendiculaire au premier, à l'aide d'un ou plusieurs registres à décalage CCD appelés registre de lecture RL1, RL2.

Les pixels P1 à P16 d'une ligne L1 à L4 sont disposés suivant un pas p1 qui peut varier selon les besoins (en fonction notamment de la définition d'image recherchée). Quand le pas p1 (qui constitue le pas des colonnes C1 à C4) devient faible, par exemple inférieur à 12 micromètres, il devient très difficile d'effectuer le transfert suivant le second sens de transfert D2 à l'aide d'un unique registre de lecture, car l'espace nécessaire à réaliser un étage d'un registre de lecture RL1, RL2 est supérieur au pas p1 des pixels P1 à P16.

En effet, la structure d'un étage d'un registre de lecture est sensiblement la même que celle d'un pixel P1 à P16 ou étage d'un registre colonne RC1 à RC4 : il faut donc en effet disposer dans chaque étage plusieurs électrodes successivement, suivant le sens de transfert envisagé, soit ici le second sens D2. Il est alors impossible de faire aboutir chaque registre colonne RC1 à RC4 dans un étage d'un unique registre de lecture ayant autant d'étages (disposés au pas p1) qu'il y a de registres colonnes.

La solution classique à ce problème est montrée à la figure 1. Elle consiste d'une part à utiliser deux registres de lecture RL1, RL2 juxtaposés, ayant respectivement des étages de lecture A1, A2 et B1, B2, et d'autre part à disposer ces étages suivant un second pas p2 double du premier pas p1.

Les deux registres de lecture RL1, RL2 sont parallèles et s'étendent perpendiculairement aux registres colonnes RC1 à RC4 par rapport auxquels ils sont disposés d'un même côté.

Une première et une seconde électrode appelées "électrode de passage" EP1, EP2 s'étendent parallèlement aux deux registres de lecture RL1, RL2 ; eues ont pour fonction d'autoriser ou non le passage des charges suivant le premier sens de transfert D1, sous la commande de signaux d'autorisations SA1, SA2. La première électrode de passage EP1 est disposée entre la zone image ZP et les registres de lecture RL1, RL2 ; et la seconde électrode de passage EP2 est disposée entre ces deux registres de lecture.

Les charges produites dans deux colonnes C1 à C4 adjacentes, c'est-à-dire consécutives, sont transférées pour être chargées dans des étages de lecture appartenant à des registres de lecture différents. Ainsi dans l'exemple représenté : les charges contenues dans la seconde et la quatrième colonne C2, C4 (colonnes non voisines) sont chargées respectivement dans le premier et le second étage de lecture B1, B2 du second registre de lecture RL2 (le plus éloigné des deux registres de lecture) ; les charges de la première et de la troisième colonnes C1, C3 sont chargées respectivement dans le premier et le second étages A1, A2 du premier registre de lecture RL1 (le plus proche).

Dans l'exemple représenté à la figure 1, les registres de lecture RL1, RL2 fonctionnent en biphasé. Par conséquent chacun de leurs étages est formé par un premier et un second sous-étages Se1, Se2 disposés successivement suivant le second sens de transfert D2, et comportant chacun un couple Pe1, Pe2 d'électrodes électriquement reliées l'une à l'autre. Les deux sous-étages Se1, Se2 d'un même étage de lecture sont commandés respectivement par des signaux de transfert SL1, SL2 ayant des phases différentes, (c'est-à-dire complémentaires durant la période de lecture dans le cas d'un fonctionnement biphasé), et qui sont appliqués à tous les sous-étages Se1, Se2 pour réaliser le transfert vers les circuits de lecture CL1, CL2, après chargement dans les étages de lecture.

Pour être chargées dans les étages B1, B2 du second registre de lecture RL2, les charges provenant des seconde et quatrième colonnes C2, C4 passent au travers du premier registre de lecture RL1. Plus précisément dans l'exemple représenté, elles sont d'abord transférées dans les premiers sous-étages Sel du premier registre de lecture RL1, d'où elles sont ensuite transférées dans les premiers sous-étages Sel du second registre de lecture RL2.

En même temps qu'est opéré le transfert des charges des colonnes C2, C4, les charges provenant des première et troisième colonnes C1, C3 sont chargées dans les seconds sous-étages Se2 du premier registre de lecture RL1. Pour empêcher le passage de ces dernières charges vers le second registre de lecture RL2, il est courant de réaliser une barrière d'isolation Bi entre les deux seconds sous-étages SE2 en vis-à-vis, appartenant à des registres de lecture RL1, RL2 différents. Cette isolation peut être réalisée sous la seconde électrode de passage EP2 par exemple, soit sous la forme d'un oxyde épais, soit sous la forme d'une zone dopée de manière appropriée. Le document Dl (l'Onde Electrique, vol. 70, n° 3, mai/juin 1990, pages 51-54, Paris, FR ; D. Herault et al. : Photocapteur matriciel à transfert de charges pour caméras de studio TVHD") décrit un dispositif de ce genre.

Cette solution à registres de lecture juxtaposés est largement utilisée à ce jour. Elle présente cependant des inconvénients tels que complexité technologique et/ou de mise en oeuvre, complexités qui se traduisent notamment par certaines difficultés à réaliser un transfert efficace entre les registres de lecture, ce qui conduit entre autres à une perte de résolution en ligne.

Ainsi par exemple, avec le montage montré à la figure 1, il est nécessaire de réaliser deux implantations dites "de canal enterré", à dopages différents, avec une très grande précision dans la différence de dopage, pour réaliser le transfert entre les deux registres de lectures : un premier canal enterré dopé N (non représenté) assure le passage des charges (suivant le premier sens de transfert D1) en amont de la seconde électrode de passage, un second canal enterré dopé N+ (non représenté) assure le passage des charges en aval de la seconde électrode de passage EP2 jusqu'au second registre de lecture RL2, la jonction de ces deux canaux s'effectuant sensiblement au milieu de la seconde électrode porte EP2 ; le champ électrique engendré par ces deux dopages différents assure le transfert. Dans une telle configuration, le champ électrique établi peut être insuffisant pour réaliser un transfert complet, vers le second registre de lecture, des charges qui sont passées par un premier sous-étage du premier registre de lecture ; il peut en résulter que lors du transfert accompli suivant le second sens de transfert D2, des charges résiduelles s'ajoutent à celles qui sont transférées vers le premier circuit de lecture CL1, ce qui entraîne une dégradation de la résolution du capteur d'images. Un autre inconvénient de cette configuration est qu'elle oblige à augmenter la valeur des tensions appliquées aux circuits de lecture.

On peut citer aussi une autre forme de réalisation, dans laquelle le passage des charges d'un registre de lecture à l'autre, s'effectue à l'aide d'un stockage momentané sous l'électrode de passage EP2. L'inconvénient de cette autre réalisation est qu'elle exige de prévoir un puits de potentiel capable de stocker toutes les charges, dans une zone connue pour être délicate, ce qui conduit à des réalisations d'une extrême précision.

Tous ces inconvénients sont particulièrement prononcés quand les registres de lecture sont du type fonctionnant en mode bi-phasé, mais il est des cas où l'utilisation de tels registres de lecture s'impose : par exemple quand les charges doivent être transférées vers un ou des circuits de lecture à très grande vitesse, il est nécessaire de fonctionner en biphasé plutôt qu'en trois, quatre ou n phases.

On connaît par ailleurs d'autres dispositifs à double registre de lecture, qui présentent des inconvénients du même genre, ou l'inconvénient d'être plus encombrants. On se référera en particulier aux documents suivants : US-A-4 949 183, Patent Abstracts of Japan, vol. 12, n° 211 (E-622) (3058) & JP-A-63 9153, 1990 IEEE INTERNATIONAL SOLID-STATE CIRCUITS CONFERENCE, DIGEST OF TECHNICAL PAPERS, San Francisco, 14-16 février 1990, pages 214, 215, 299 ; K. Yonemoto et al. : "Image sensor, processors and displays".

La présente invention concerne un dispositif photosensible à registres de lecture juxtaposés, qui ne présente pas les inconvénients ci-dessus cités.

Par l'expression "registre de lectures juxtaposé" nous entendons un montage du type décrit ci-dessus, dans lequel d'une part, au moins deux registres de lecture sont d'un même côté par rapport aux colonnes avec l'un des registres plus près des colonnes que l'autre, les étages qui constituent ces registres étant disposés suivant un pas p2 correspondant au pas p1 des colonnes de pixel multiplié par le nombre de registres ; et dans lequel d'autre part les charges de deux colonnes consécutives sont chargées dans des registres de lectures différents, les charges transférées dans le registre le plus éloigné passant par un sous-étage du registre le plus proche.

L'invention, propose un dispositif tel que défini dans la revendication 1.

Ceci permet notamment d'établir, pendant la phase de chargement des registres de lecture, une différence de potentiel relativement importante entre les sous-étages du premier et du second registre de lecture, et engendrer ainsi des champs électriques beaucoup plus favorables au transfert des charges.

Les caractéristiques et avantages de l'invention ressortiront mieux à la description qui suit, donnée à titre d'exemple non limitatif en référence aux dessins annexés dans lesquels :
- la figure 1 déjà décrite montre l'organisation générale d'un dispositif photosensible CCD d'un type connu ;
- la figure 2 montre schématiquement un dispositif photosensible CCD suivant l'invention ;
- la figure 3 représente la forme d'une électrode finale d'une zone photosensible montrée à la figure 2 ;
- la figure 4 est une vue en coupe représentant des électrodes montrées à la figure 3 ;
- la figure 4b représente des potentiels engendrés sous les électrodes de la figure 4 ;
- les figures 5a à 5g constituent un chronogramme de signaux appliqués aux électrodes montrées à la figure 4 ;
- les figures 6 à 6f illustrent des potentiels engendrés pendant le fonctionnement dans une colonne de rang pair ;
- les figures 7 à 7g montrent des potentiels engendrés pendant le fonctionnement dans une colonne de rang impair.

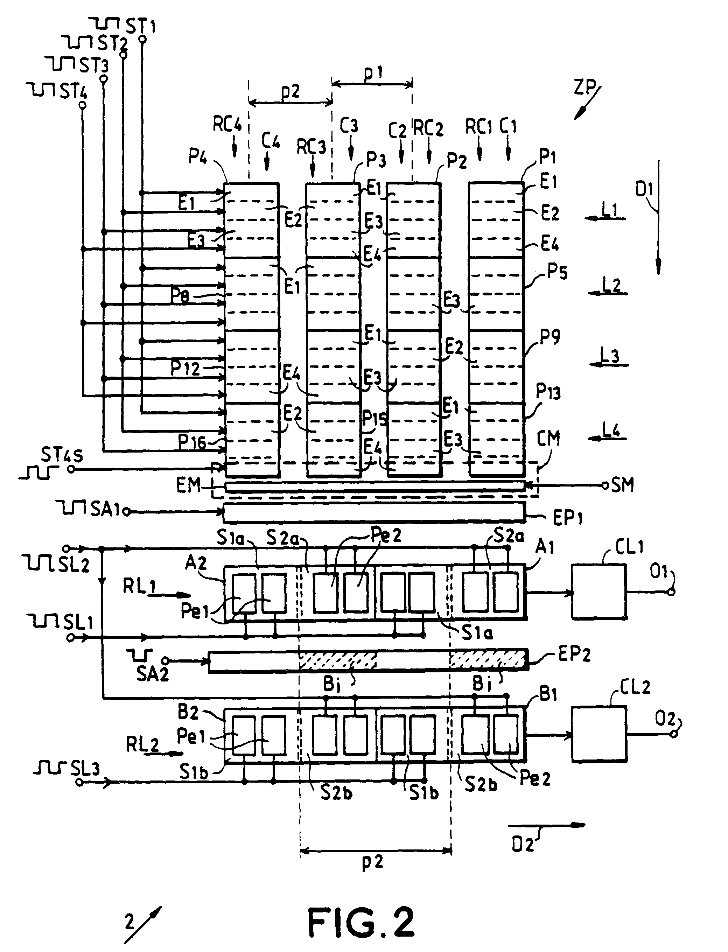

La figure 2 montre de façon schématique un dispositif photosensible 2 à transfert de charge (CCD) conforme à l'invention. Le dispositif photosensible 2 comporte une zone photosensible ZP formée par une pluralité de zones élémentaires photosensibles ou pixels P1 à P16.

Le dispositif photosensible 2 est d'un type semblable à celui montré à la figure 1, en ce qu'il comporte des registres de lecture RL1, RL2 juxtaposés pour transférer jusque dans des circuits de lecture CL1, CL2, des charges produites par les pixels P1 à P16.

Les pixels P1 à P16 sont disposés suivant N lignes et M colonnes avec d'une part un nombre M de colonnes égal ou supérieur à 2, et d'autre part un nombre N de lignes égal ou supérieur à 1 (le dispositif photosensible 1 peut éventuellement constituer un barrette ayant une unique ligne). Dans l'exemple non limitatif décrit, pour simplifier la figure 2 seulement quatre lignes L1 à L4 et quatre colonnes C1 à C4 sont représentées, formées à l'aide de seize pixels P1 à P16.

Dans le sens des lignes L1 à L4, les pixels P1 à P16 sont disposés suivant un pas p1 qui constitue le pas suivant lequel se succèdent les colonnes C1 à C4.

Dans le sens des colonnes C1 à C4, les successions de pixels P1 à P16 dans chacune de ces colonnes C1 à C4 constituent un registre à décalage (appelé registre colonne RC1 à RC4) dont chaque étage est formé par un pixel.

Les charges produites dans les colonnes C1 à C4 sont transférées à l'aide de ces registres colonnes, suivant un premier sens de transfert D1 jusque dans les registres de lecture RL1, RL2.

Les registres de lecture RL1, RL2 sont disposés du côté d'une même extrémité des colonnes C1 à C4 et perpendiculairement à ces dernières. Ils comportent des étages de lecture respectivement A1, A2 et B1, B2 et dans chacun de ces registres, ces étages sont disposés suivant un second pas p2 égal au pas p1 multiplié par le nombre de registres de lecture ; dans l'exemple p2 = p1 x 2.

Le premier registre de lecture RL1 disposé le plus près de la zone photosensible ZP est séparé de cette dernière par une première électrode de passage EP1, commandée par un signal d'autorisation SA1 ; une seconde électrode de passage EP2 commandée par un second signal d'autorisation SA2 est disposée entre les deux registres de lecture RL1, RL2.

Le transfert dans les registres colonnes RC1 à RC4 peut s'exécuter suivant un mode biphasé ; trois phases, quatre phases ou davantage. Dans l'exemple non limitatif représenté, il est accompli suivant le mode quatre phases. A cet effet, chaque pixel P1 à P16 comporte 4 électrodes ou sous-étages E1, E2, E3, E4 qui se succèdent suivant le premier sens de transfert D1. Ces électrodes E1 à E4 sont commandées par des signaux de transfert ST1 à ST4 ayant des phases différentes.

Comme dans l'exemple de la figure 1, les charges produits dans des colonnes C1 à C4 consécutives sont transférées dans des registres de lecture différents.

Dans l'exemple représenté, les charges produites dans les première et troisième colonnes C1 et C3 sont destinées à être chargées respectivement dans les étages A1 et A2 du premier registre de lecture RL1, et les charges produites dans les seconde et quatrième colonne C2 et C4 sont destinées à être chargées dans les étages B1 et B2 du second registre de lecture RL2, le plus éloigné.

Les registres de lecture RL1, RL2 sont du type fonctionnant en biphasé : en conséquence chacun de leurs étages comporte des paires d'électrodes PE1, PE2 avec lesquelles sont formées deux sous-étages par étage : soit un premier et un second sous-étages S1a, S2a dans chacun des étages du premier registre RL1, et un premier et un second sous-étage S1b, S2b pour les étages du second registre de lecture RL2 ; ces sous-étages se succèdent suivant le second sens de transfert D2.

Suivant une caractéristique de l'invention, un circuit de multiplexage CM est interposé entre la zone photosensible ZP et les registres de lecture RL1, RL2 afin, dans un premier temps, d'autoriser le passage vers ces derniers uniquement des charges destinées à être transférées dans le second registre RL2 (le plus éloigné) ; ceci en bloquant les charges destinées à être chargées dans le premier registre de lecture RL1 ; puis dans un second temps, de charger le premier registre RL1.

Dans l'exemple non limitatif représenté, le circuit multiplexeur CM comporte une électrode de multiplexage EM commandée par un signal de multiplexage SM. L'électrode de multiplexage s'étend parallèlement aux registres de lecture RL1, RL2 entre la première électrode de passage EP1 et la quatrième ligne L4 de pixels qui est la ligne la plus proche de cette électrode de passage. Plus précisément, l'électrode de multiplexage EM chevauche partiellement les dernières électrodes (E4) considérées suivant le sens D1, et qui dans l'exemple constituent les quatrième sous-étage des pixels P13, P14, P15 et P16.

Lors du transfert des charges dans les registres colonnes. RC1 à RC4 accompli sous la commande des signaux de transfert ST1 à ST4, en vue de réaliser le chargement des registres de lecture RL1, RL2, le circuit de multiplexage CM envole d'abord par exemple les charges produites dans toutes les colonnes de rang pair, les colonnes C2 et C4 dans l'exemple, vers un premier sous-étage S1a du premier registre de lecture RL1 ; d'où ces charges passent ensuite vers un premier sous-étage S1b (en vis-à-vis) du second registre de lecture RL2 ; alors que les charges des colonnes C1 et C3 de rang impair sont maintenues dans le circuit de multiplexage CM.

Les électrodes qui réalisent les premiers sous-étages S1b du second registre de lecture sont électriquement isolées, c'est-à-dire indépendantes des électrodes qui réalisent les premiers sous-étages S1a du 1er registre RL1, contrairement à l'art antérieur où ces électrodes sont reliées et reçoivent toujours des signaux identiques.

Il est à noter que dans cette phase de chargement des registres de lecture, le premier signal de commande SL1 étant mis au niveau bas alors que le troisième signal de commande SL3 est au niveau haut, il existe entre les deux registres de lecture RL1, RL2, c'est-à-dire entre les deux premiers sous-étages en vis-à-vis S1a, S1b de ces deux registres, un champ électrique important qui facilite un transfert efficace des charges.

Il est à noter en outre que, le second signal de commande SL2 étant au niveau bas, le passage des charges entre les étages d'un même registre de lecture n'est pas possible dans cette phase de transfert accomplie suivant le premier sens D1.

Ensuite, le second registre de lecture RL2 ayant reçu les charges des colonnes C2, C4 de rangs pairs, les charges contenues dans le circuit de multiplexage CM et provenant des colonnes C1 et C3 de rangs impairs, sont transférées et chargées dans les seconds sous-étages S2a du premier registre de lecture RL1.

Les deux registres de lecture RL1, RL2 étant chargés, le transfert des charges suivant le second sens D2 (pour transporter les charges jusqu'aux circuits de lecture CL1, CL2) peut alors débuter. Pendant ce transfert vers les circuits de lecture, tous les premiers sous-étages S1a, S1b sont commandés de manière classique, c'est-à-dire que les signaux SL1 et SL3 ont une même phase, et sont complémentaires du second signal de commande SL2 appliqués à tous les seconds sous-étages S2a, S2b.

Ainsi le fonctionnement des registres de lecture RL1, RL2 s'effectue de façon classique dans la phase de lecture proprement dite accomplie suivant le second sens de transfert D2, c'est seulement dans la phase de chargement des registres de lecture RL1, RL2, que le troisième signal de commande SL3 remplace le premier signal SL1 pour commander les premiers sous-étages S1b du 2ème registre de lecture RL2.

Il faut noter encore que avant de faire débuter la phase de lecture proprement dite, c'est-à-dire le transfert des charges vers les circuits de lecture, il faut achever la phase de chargement pour que dans les deux registres de lecture RL1, RL2, les charges soient à un même rang, c'est-à-dire dans de mêmes sous-étages de façon à supprimer un décalage de position entre les charges contenues dans un registre de lecture par rapport à celles contenues dans l'autre registre. A cet effet, on commande le second registre de lecture RL2 pour que les charges contenues dans les premiers sous-étages S1b du second registre RL2, soient transférées dans un second sous-étage S2b de ce second registre de lecture RL2.

L'indépendance électrique entre les électrodes des premiers sous-étages S1a appartenant au premier registre de lecture RL1 et les électrodes des premiers sous-étages S1b appartenant au second registre de lecture RL12, permet d'accroître l'efficacité du transfert des charges entre ces deux registres, indépendemment des effets qui résultent de l'utilisation de l'électrode de multiplexage EM. Il est possible aussi de ne pas utiliser d'électrode de multiplexage, c'est-à-dire de ne pas bloquer les charges provenant de certaines colonnes, si on rend électriquement indépendantes les unes des autres toutes les électrodes d'un étage A1, A2, B1, B2 des deux registres de lecture RL1, RL2, de façon à commander ces électrodes par des potentiels indépendants pendant la phase de chargement de ces registres de lecture.

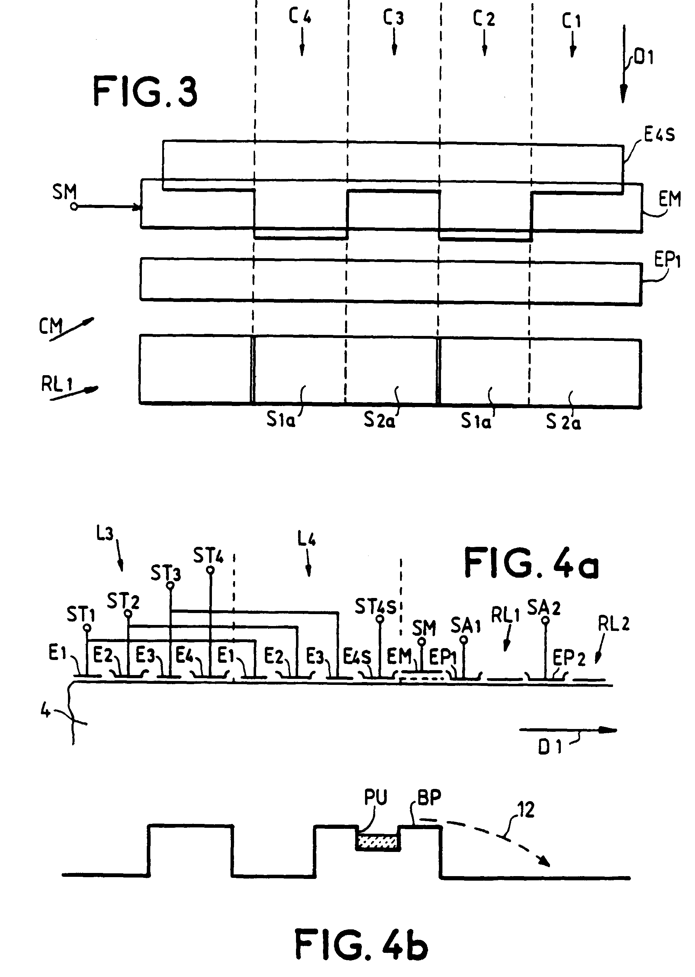

La figure 3 est une vue de dessus semblable à la figure 2 et montre à titre d'exemple non limitatif une forme de réalisation possible du circuit de multiplexage CM.

Il est à noter que le fonctionnement opéré dans les colonnes C1 à C4 pour réaliser le transfert dans le sens D1, est modifié à partir du dernier sous-étage de la zone photosensible ZP, c'est-à-dire le quatrième sous-étage (dans l'exemple représenté) qui est formé par la dernière électrode E4 la plus proche de l'électrode de multiplexage EM, et qui est appelée électrode finale E4S dans la suite de la description.

Il est courant que les électrodes qui définissent les différents sous-étages E1 à E4 d'un pixel P1 à P16 soient constituées à l'aide d'une même électrode conductrice pour tous les sous-étages d'une même ligne L1 à L4. Une telle disposition est montrée sur la figure 3 pour la quatrième et dernière électrode ou électrode finale E4S.

L'électrode finale E4S coopère avec l'électrode de multiplexage EM, à laquelle est appliqué un signal de multiplexage SM pouvant avoir un niveau haut (positif dans l'exemple) et un niveau bas (par exemple à OV, c'est-à-dire le potentiel du substrat semiconducteur qui porte les différentes électrodes).

Quand le signal de multiplexage SM est au niveau bas, il impose sous l'électrode de multiplexage EM (dans les colonnes impaires C1, C3) un potentiel tel que les charges stockées sous l'électrode finale E4S sont bloquées sous cette électrode et ne sont pas transférées suivant le premier sens de transfert D1.

Suivant le fonctionnement qui a été décrit plus haut, ce blocage des charges doit intervenir uniquement pour les charges contenues dans les colonnes C1, C3 de rangs impairs.

A cet effet, l'électrode de multiplexage est réalisée au dessus de l'électrode finale E4S (dont elle est séparée par une couche isolante de façon en elle-même classique), et l'électrode finale E4S est découpée par des créneaux, de manière à être interposée entre le substrat et l'électrode de multiplexage EM au dessus d'une colonne C2, C4 de rang pair, et ne pas être ainsi interposée dans le cas d'une colonne C1, C3 de rang impair.

Une telle dispositlon est illustrée également par la figure 4 qui est une vue en coupe suivant une colonne C1 à C4.

La figure 4 montre schématiquement, suivant le premier sens de transfert D1, la succession d'électrodes E1, E2, E3, E4 réalisées sur un substrat 4 et qui forment les sous-étages des pixels appartenant aux lignes L3, L4. Ces sous-étages sont suivis par l'électrode de multiplexage EM, la première électrode de passage EP1, le premier registre de lecture RL1, la seconde électrode de passage EP2, et le second registre de lecture RL2.

Les sous-étages ou électrodes E1, E2, E3, E4 reçoivent des signaux de transfert respectivement ST1, ST2, ST3, ST4 identiques pour toutes les lignes, à l'exception de la quatrième électrode E4S qui forme l'électrode finale.

L'électrode finale E4S reçoit en effet un signal de transfert ST4S particulier en ce que, par rapport aux autres signaux de transfert, son niveau bas doit avoir une valeur supérieure à celle des niveaux bas des autres signaux de transfert. Par exemple si pour les autres signaux de transfert la valeur de leur niveau bas est 0 volt (potentiel du substrat par exemple) et que la valeur du niveau haut est + 10 volts : la valeur du niveau haut du signal de transfert ST4S peut être identique, mais la valeur de son niveau bas doit être par exemple de 3 volts, afin de laisser subsister un puits de potentiel permettant de stocker des charges quand le signal de multiplexage SM appliqué à l'électrode multiplexage EM est au niveau bas.

On peut observer que sur la figure 4, l'électrode finale E4s est prolongée en traits pointillés sous l'électrode de multiplexage EM. Il faut considérer que quand la figure 4 s'applique à représenter une colonne de rang impair C1 ou C3, l'électrode finale E4s ne s'étend pas sous l'électrode de multiplexage EM, ce qui rend celle-ci active. Au contraire pour la colonne C2, C4 de rang pair, l'électrode finale E4s s'étend sous l'électrode de multiplexage EM qui ; dans ce cas, n'exerce aucune action quelle que soit le niveau du signal SM qui lui est appliqué.

Dans cette configuration, quand le signal de multiplexage SM est appliqué avec un niveau bas (O volt ou voisin de 0 volt), il détermine sous l'électrode de multiplexage EM un potentiel qui constitue une barrière de potentiel, mais ceci uniquement dans les colonnes C1, C3 de rang impair, comme représenté à la figure 4b.

La figure 4b illustre les potentiels engendrés dans le substrat 4, sous les différentes électrodes montrées à la figure 4, sauf sous la seconde électrode de passage EP2 et le second registre de lecture RL2. Suivant une représentation classique, en matière de circuits à transfert de charges, les potentiels positifs vont en croissant vers le bas.

Dans l'exemple montré à la figure 4b les signaux de transfert ST1 et ST2 sont au niveau haut ; les signaux de transfert ST3, ST4, ST4S sont au niveau bas ; le signal de multiplexage SM est au niveau bas : le premier signal d'autorisation de passage SA1 est au niveau haut. Dans ces conditions, en supposant qu'à un instant qui a précédé celui illustré à la figure 4b, des charges aient été stockées sous l'électrode finale E4S, ces charges restent bloquées sous cette électrode de sortie quand il s'agit d'une colonne C1 à C3 impaire, du fait que l'électrode de multiplexage EM étant active elle impose un potentiel bas qui forme une barrière de potentiel BP, laquelle s'oppose à l'écoulement des charges stockées sous l'électrode finale E4S. Comme expliqué plus haut, il faut pour cela que le niveau bas du signal ST4S soit positif par rapport aux signaux ST3 et SM pour que, même au niveau bas du signal ST4S, soit formé un puits de potentiel PU capable de contenir toutes les charges qui étaient déjà stockées sous l'électrode finale E4S quand le signal de transfert ST4S était à l'état haut. Ceci peut être obtenu en jouant en outre sur la surface de l'électrode de sortie E4S.

Dans le cas d'une colonne C2, C4 de rang pair, l'électrode de multiplexage EM est inopérante. C'est l'électrode finale E4S qui impose son potentiel, de telle sorte qu'il n'est pas constitué de barrière de potentiel telle que BP, et que les charge sont déversées vers le registre de lecture RL1, comme symbolisé sur la figure 4b par une flèche 12.

Bien entendu le circuit de multiplexage peut être réalisé de manière différente, et d'autres fonctionnements sont possibles, l'important étant de retenir les charges provenant d'une colonne tout en laissant passer les charges provenant d'une colonne voisine.

On rappelle que suivant l'un des fonctionnements classiques d'un capteur d'images à transfert de charges, un cycle de fonctionnement comprend une phase d'accumulation des charges, suivie de N fois une phase de chargement des registres de lecture plus une phase de lecture, puis à nouveau une phase d'accumulation, etc ; N étant égal au nombre de lignes telles que les lignes L1 à L4. La phase de chargement est accomplie suivant le premier sens de transfert D1 : elle comprend à chaque fois un transfert d'un étage dans les colonnes C1 à C4 ainsi que le chargement, dans les étages des registres de lecture, des charges déjà stockées sous les électrodes finales E4S. La phase de lecture est accomplie ensuite et consiste en un transfert effectué suivant le second sens D2, transfert durant lequel toutes les charges contenues dans un registre de lecture RL1, RL2 sont transportées vers un circuit de lecture et lues par ce dernier.

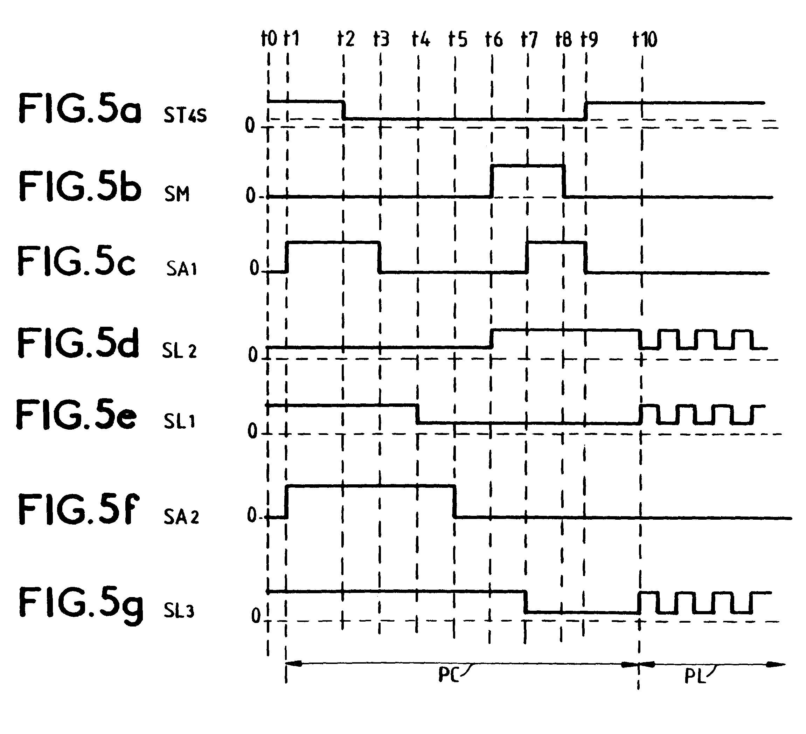

Les figures 5a à 5g constituent un chronogramme des différents signaux appliqués, durant une phase de chargement des deux registres de lectrue RL1, RL2, aux différentes électrodes qui dans les colonnes C1 à C4 se succèdent suivant le premier sens de transfert D1, depuis l'électrode finale E4S jusqu'au second registre de lecture RL2.

Les différents signaux représentés peuvent varier entre un niveau bas proche ou correspondant au potentiel du substrat (soit le niveau 0 volt par exemple), et un niveau haut positif ou négatif suivant le dopage du substrat. En supposant par exemple que le substrat soit dopé du type P, le niveau haut est positif.

La figure 5a représente le signal de transfert ST4S appliqué aux électrodes finales E4S. Ce signal peut varier entre un niveau haut ayant une même valeur que les autres signaux, et un niveau bas qui lui est plus positif que celui des autres signaux comme il a déjà été indiqué précédemment.

La figure 5b représente le signal de multiplexage SM appliqué à l'électrode de multiplexage EM.

La figure 5c représente le premier signal d'autorisation SA1 appliqué à la première électrode de passage EP1.

La figure 5d représente le second signal de commande SL2 appliqué aux seconds sous-étages Sa2, Sb2 des registres de lecture RL1, RL2. Pour une meilleure efficacité du fonctionnement dans la phase de chargement, la valeur du niveau bas de ce signal de commande SL2 est plus positive que zéro volt, avec par exemple une valeur égale à celle du niveau bas du signal de transfert ST4S.

La figure 5e montre le premier signal de commande SL1 appliqué aux premiers sous-étages Sa1 du premier registre de lecture RL1. De préférence, (mais non obligatoirement) la valeur du niveau bas de ce premier signal de commande SL1 est la même que celle du second signal de commande SL2.

La figure 5f représente le second signal d'autorisation SA2 appliqué à la seconde électrode de passage EP2.

La figure 5g représente le troisième signal de commande SL3 appliqué aux premiers sous-étages S1b du second registre de lecture RL2. Ce troisième signal SL3 a lui aussi un niveau bas dont la valeur est de préférence plus positive que 0 volt, comme le premier et le second signal de commande SL1, SL2.

A un instant t0 qui précède la période de chargement :
- le signal de transfert ST4S (figure 5a) est au niveau haut ;
- le signal de multiplexage SM (figure 5b) est au niveau bas ;
- le premier signal d'autorisation SA1 (figure 5c) est au niveau bas ;
- le second signal de commande SL2 (figure 5d) est au niveau bas ;
- le premier signal de commande SL1 (figure 5d) est au niveau haut ;
- le second signal d'autorisation SA2 (figure 5f) est au niveau bas ;
- le troisième signal de commande SL3 (figure 5g) est au niveau haut.

A un instant t1 qui suit t0 et qui marque le début de la période de chargement PC :
- le premier signal d'autorisation SA1 passe au niveau haut ;
- le second signal d'autorisation SA2 passe au niveau haut ;

A un instant t2 qui suit t1 : le signal de transfert ST4S appliqué à l'électrode finale E4S passe au niveau bas. Ceci marque le début du transfert vers le registre de lecture RL2 des charges d'une colonne paire.

A un instant t3 qui suit t2 : le premier signal d'autorisation SA1 passe au niveau bas.

A un instant t4 qui suit t3 : le premier signal de commande SL1 passe au niveau bas.

A un instant t5 qui suit t4, le second signal d'autorisation SA2 passe au niveau bas.

A un instant t6 qui suit t5 :
- le signal de multiplexage SM passe au niveau haut ;
- le second signal de commande SL2 passe au niveau haut.

A un instant t7 qui suit t6 :
- le premier signal d'autorisation SA1 passe au niveau haut d'où résulte le transfert des charges des colonnes impaires vers le premier registre de lecture RL1 ;
- le troisième signal de commande SL3 passe au niveau bas ; d'où résulte un transfert dans le second registre de lecture RL2 des charges qui passe d'un premier sous-étage S1b à un second sous-étage S2b.

A un instant t8 qui suit t7, le signal de multiplexage SM passe au niveau bas.

A un instant t9 qui suit t8 :
- le signal de transfert ST4S passe au niveau haut ;
- le premier signal d'autorisation SA1 passe au niveau bas, ce qui marque la fin de la période de chargement des registres de lecture.

A un instant t10 qui suit t9 :
- le premier et le troisième signal de commande SL1, SL3 passent au niveau haut, alors que le second signal de commande SL2 passe au niveau bas. Ceci marque le début de la période de lecture PL, durant laquelle les deux registres de lecture RL1, RL2 transfèrent les charges qu'ils contiennent vers les circuits de lecture.

Ces trois signaux de commande SL1, SL2, SL3 sont constitués chacun par une succession de créneaux ayant une même fréquence. On remarque que le premier et le troisième signal de commande ont une même phase, phase qui est complémentaire de celle du second signal de commande SL2. On constate qu'ainsi les sous-étages en visà-vis S1a, S1b et S2a, S2b appartenant à des registres RL1 et RL2 différents sont commandés avec une même phase ; ceci se remarque particulièrement pour les premiers sous-étages S1a et S1b qui, dans la période de chargement, sont au contraire commandés par des signaux de phases différentes.

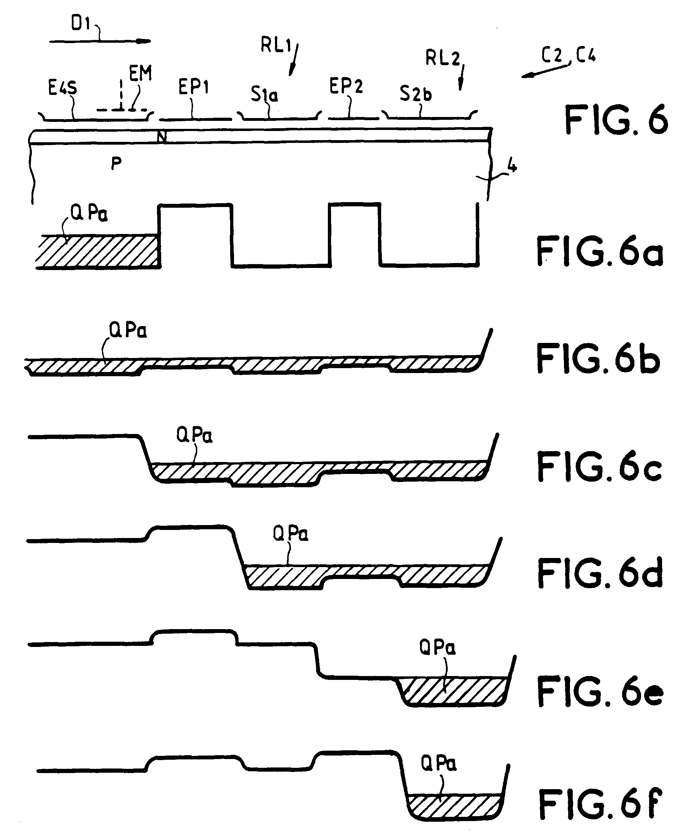

Les figures 6a à 6f illustrent les potentiels engendrés dans le substrat sous les électrodes d'une colonne C2, C4 de rang pair telle que représentée en coupe à la figure 6. Ces potentiels sont ceux engendrés aux instants cités en référence aux figures 5a à 5g.

La figure 6 montre une succession d'électrodes d'une colonne C2, C4 de rang pair, à partir de l'électrode finale et suivant le premier sens de transfert D2 : on trouve successivement l'électrode finale E4S, la première électrode de passage EP1, les électrodes formant un premier sous-étage S1a du premier registre de lecture, la seconde électrode de passage EP2, les électrodes qui forment le premier sous-étage S1b du second registre de lecture RL2. Ces électrodes sont réalisées sur le substrat 4, au dessus d'une couche dopée N qui constitue un canal enterré. L'électrode de multiplexage EM n'étant pas active dans une colonne C2 ou C4 de rang pair, elle est montrée en pointillés.

La figure 6a se rapporte à l'instant t0. Elle montre que sous l'électrode finale E4S est créé un puits de potentiel susceptible de contenir une quantité de charge QPa.

La figure 6b se rapporte à l'instant t1, elle montre que les charges QPa sont réparties sous les électrodes E4S, EP1, S1a, EP2, S1b.

La figure 6c montre qu'à l'instant t2 les charges qui étaient sous E4S sont déversées sous EP1, SAa, EP2 et S1b.

La figure 6d montre qu'à l'instant t3 les charges qui étaient contenues sous EP1 sont déversées sous S1a, EP2 et S1b.

La figure 6e montre qu'à l'instant t4 les charges QPa sont contenues uniquement dans le premier sous-étage S1b du second registre RL2, suite d'une part au passage au niveau bas du second signal de commande SL2, et d'autre part du fait que dans l'exemple représenté, le potentiel sous EP2 est moins positif que sous S1b (le niveau haut du second signal d'autorisation SA2 est par exemple moins positif de 2 volts par exemple que les autres signaux). Ceci n'est pas indispensable, mais peut éviter un retour en arrière des charges.

La figure 6f montre qu'à l'instant t5 le potentiel sous EP2 est devenu négatif, ce qui confirme le stockage des charges Qpa sous S1b.

La quantité de charges QPa créée dans une colonne C2, C4 paire ayant été ainsi transférée dans un premier sous-étage S1b du second registre de lecture RL2, après avoir traversé le premier registre de lecture RL1, elle est ensuite transférée perpendiculairement au plan de la figure (suivant le second sens de transfert D2) jusque dans un second sous-étage S2b du second registre de lecture RL2.

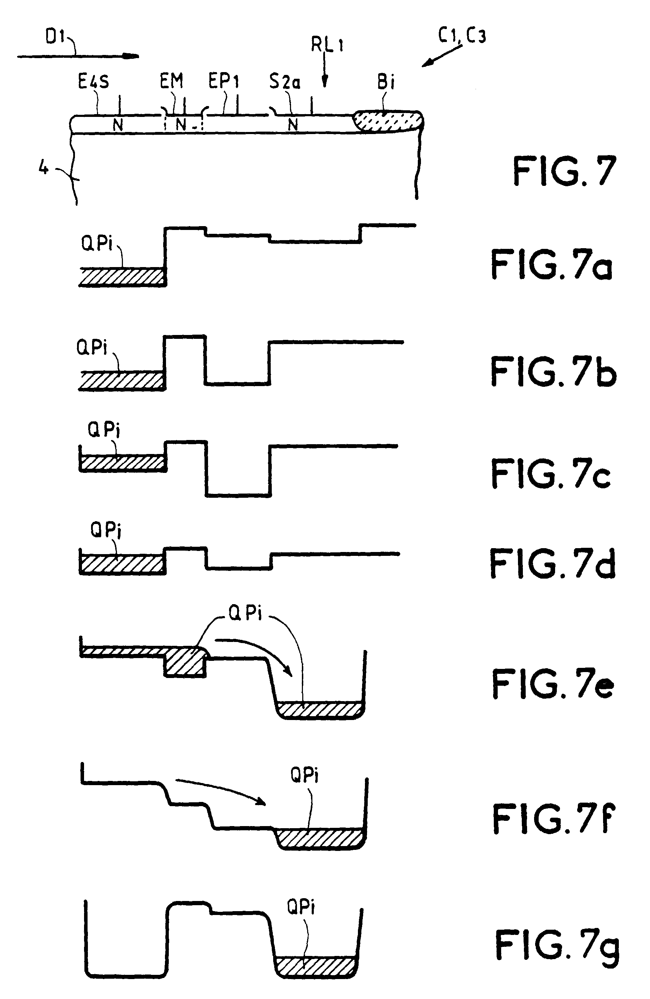

Les figures 7a à 7j illustrent les potentiels engendrés sous les électrodes d'une colonne C1, C3 de rang impair, telle que représentée partiellement par une vue en coupe à la figure 7. Ces potentiels sont ceux engendrés aux instant cités en référence aux figures 5a à 5g.

La figure 7 montre des électrodes d'une colonne de rang impair C1, C3 qui se succèdent suivant le premier sens de transfert D1, à partir d'une électrode finale E4S. Après l'électrode finale E4S on trouve successivement, l'électrode de multiplexage EM, la première électrode de passage EP1, des électrodes qui forment un second sous-étage S2a du premier registre de lecture RL1, puis une barrière d'isolement Bi qui empêche tout transfert de charges au delà de ce second sous-étage S2a. Ces électrodes sont réalisées sur le substrat 4 au dessus d'une couche dopée N formant un canal enterré.

La figure 7a se rapporte à l'instant t0. Elle montre que sous l'électrode finale E4S est créé un puits de potentiel contenant une quantité de charges QPi collectées dans une colonne impaire C1, C3. Les potentiels sous les autres électrodes sont positifs par rapport à celui qui créé sous E4S. Il est à noter que pour un meilleur fonctionnement, il est avantageux (mais non obligatoire) de réaliser une zone dopée N-dans le canal enterré N, sous l'électrode de multiplexage EM. Ceci confère au potentiel sous l'électrode EM une valeur encore plus négative.

La figure 7b montre qu'à l'instant t1 toutes les charges QPi restent stockées sous l'électrode finale E4S, bien que le potentiel soit devenu positif sous l'électrode de passage EP1.

La figure 7c montre qu'à l'instant t2 les charges QPi restent retenues sous l'électrode finale E4S, alors que dans une colonne C2, C4 de rang pair, à cet instant les charges QPa quittent cette électrode.

La figure 7d montre qu'à l'instant t3 le potentiel sous l'électrode de passage EP1 devient négatif, sans aucune influence sur les charges QPi qui restent stockées sous E4S ; ceci est conservé également pour les instants t4 et t5.

La figure 7e montre qu'à l'instant t6 le potentiel devient positif sous l'électrode multiplexage EM et sous les électrode qui constituent le second sous-étage S2a du premier registre de lecture RL1, de telle sorte qu'une partie des charges QPi est déversée dans le second sous-étage S2a.

La figure 7f montre qu'à l'instant t7 le potentiel sous la première électrode de passage EP1 devient plus positif : toutes les charges restant sous l'électrode finale E4S sont alors déversées vers le second sous-étage S2a.

La figure 7g montre qu'à l'instant t9 toutes les charges QPi sont contenues dans le puits de potentiel formé par le second sous-étage S2a du premier registre de lecture RL1.

## Revendications

1. Dispositif photosensible à transfert de charges, comportant un arrangement matriciel de zones élémentaires photosensibles ou pixels (P1 à P16), au moins deux registres de lectures (RL1, RL2) distincts, les charges photosensibles issues de certaines colonnes (C1, C3) étant chargées dans le premier registre (RL1) tandis que les charges issues d'autres colonnes (C2, C4) transitent à travers le premier registre (RL1) pour être chargées dans le second (RL2), caractérisé en ce que les registres de lecture comportent des étages disposés suivant un pas égal à n fois le pas des colonnes, n étant le nombre des registres de lecture, en ce que chaque étage des registres de lecture comporte au moins deux sous-étages se succédant suivant un sens de transfert perpendiculaire aux colonnes, les premiers et les seconds sous-étages du premier registre de lecture étant vis-à-vis respectivement des premiers et des seconds sous-étages du second registre de lecture, les charges transférées dans le second registre transitant par les premiers sous-étages du premier registre, et le potentiels appliqués aux électrodes du premier registre pendant le chargement étant différents des potentiels appliquées aux électrodes du second registre dans le même temps.

2. Dispositif photosensible suivant la revendication 1, caractérisé en ce que des moyens de transfert sont prévus pour :
- dans un premier temps inhiber le chargement dans le premier registre (RL1) tout en autorisant le chargement du second registre (RL12) à travers le premier
- et dans un deuxième temps pour charger le premier registre (RL1).

3. Dispositif photosensible suivant l'une des revendications précédentes caractérisé en ce que les registres de lecture sont du type fonctionnant en mode biphasé.

4. Dispositif photosensible suivant l'une des revendications précédentes, chaque pixel (P1 à P16) comportant au moins deux électrodes (E1, E2, E3, E4) se succèdant dans le sens des colonnes (C1 à C4) et suivant un premier sens de transfert (D1), dans chaque colonnes (C1 à C4), la dernière électrode (E4S) du dernier pixel constituant une électrode dite électrode finale, au moins une électrode de passage (EP1) étant disposée entre la zone photosensible (ZP) et les registres de lecture (RL1, RL2) afin d'interdire ou autoriser des transferts de charges vers ces derniers, caractérisé en ce qu'au moins une électrode dite de multiplexage (EM) est disposée entre les pixels (P1 à P16) et l'électrode de passage (EP1), l'électrode de multiplexage (EM) coopérant avec l'électrode de passage (EP1) et les électrodes de sortie (E4S) pour retenir les charges produites dans au moins une colonne (C1, C3) sur plusieurs colonnes consécutives.

5. Dispositif photosensible suivant la revendication 4, caractérisé en ce que les registres de lecture (RL1, RL2) sont au nombre de deux et en ce que l'électrode de multiplexage (EM) retient les charges d'une colonne sur deux.

6. Dispositif photosensible suivant l'une quelconque des revendications 4 ou 5, les différentes électrodes (E1 à E4, E4S, EM) étant portées par un substrat (4) semiconducteur, caractérisé en ce que les électrodes finales (E4S) sont interposées entre l'électrode de multiplexage (EM) et le substrat (4) uniquement dans les colonnes (C2, C4) dont les charges ne sont pas retenues à l'aide de l'électrode de multiplexage (EM).

7. Dispositif photosensible suivant l'une quelconque des revendications 4 ou 5 ou 6, caractérisé en ce que les électrodes finales (E4S) étant commandées par des signaux de tension (ST4S) pouvant varier entre un niveau haut et un niveau bas, la valeur du niveau bas est telle qu'elle permet, en coopération avec l'électrode de multiplexage, de constituer un puits de potentiel sous les électrodes finales des colonnes (C1, C3) dont les charges sont retenues.

## Patentansprüche

1. Lichtempfindliche Vorrichtung mit Ladungsübertragung, mit einer Matrixanordnung von lichtempfindlichen Elementarzonen oder Pixeln (P1 bis P16), wenigstens zwei getrennten Leseregistern (RL1, RL2), wobei die von bestimmten Spalten (C1, C3) abgegebenen lichtempfindlichen Ladungen in das erste Register (RL1) geladen werden, während die von anderen Spalten (C2, C4) abgegebenen Ladungen durch das erste Register (RL1) hindurchgehen, um in das zweite Register (RL2) geladen zu werden, dadurch gekennzeichnet, daß die Leseregister Stufen aufweisen, die gemäß einer Schrittweite angeordnet sind, die gleich dem n-fachen der Schrittweite der Spalten ist, wobei n die Anzahl der Leseregister ist, und daß jede Stufe der Leseregister wenigstens zwei Unterstufen aufweist, die in einer zu den Spalten senkrechten Übertragungsrichtung aufeinander folgen, wobei die ersten und die zweiten Unterstufen des ersten Leseregisters den ersten bzw. zweiten Unterstufen des zweiten Leseregisters gegenüberliegen, wobei die in das zweite Register übertragenen Ladungen durch die ersten Unterstufen des ersten Registers hindurchgehen und wobei die an die Elektroden des ersten Registers während des Ladens angelegten Potentiale von den an die Elektroden des zweiten Registers in derselben Zeit angelegten Potentialen verschieden sind.

2. Lichtempfindliche Vorrichtung nach Anspruch 1, dadurch gekennzeichnet, daß Übertragungsmittel vorgesehen sind, um:
- in einem ersten Zeitabschnitt das Laden in das erste Register (RL1) zu verhindern, während sie das Laden des zweiten Registers (RL12) durch das erste hindurch ermöglichen,
- und in einem zweiten Zeitabschnitt das erste Register (RL1) zu laden.

3. Lichtempfindliche Vorrichtung nach einem der vorhergehenden Ansprüche, dadurch gekennzeichnet, daß die Leseregister vom im Zweiphasenmodus arbeitenden Typ sind.

4. Lichtempfindliche Vorrichtung nach einem der vorhergehenden Ansprüche, wobei jedes Pixel (P1 bis P16) wenigstens zwei Elektroden (E1, E2, E3, E4) aufweist, die in der Richtung der Spalten (C1 bis C4) und in einer ersten Übertragungsrichtung (D1) in jeder Spalte (C1 bis C4) aufeinander folgen, wobei die letzte Elektrode (E4S) des letzten Pixels eine Elektrode bildet, welche Endelektrode genannt wird, wobei wenigstens eine Durchgangselektrode (EP1) zwischen der lichtempfindlichen Zone (ZP) und den Leseregistern (RL1, RL2) angeordnet ist, um Ladungsübertragungen zu den Leseregistern zu verhindern oder zu ermöglichen, dadurch gekennzeichnet, daß wenigstens eine Elektrode, die Multiplexelektrode (EM) genannt wird, zwischen den Pixeln (P1 bis P16) und der Durchgangselektrode (EP1) angeordnet ist, wobei die Multiplexelektrode (EM) mit der Durchgangselektrode (EP1) und den Ausgangselektroden (E4S) zusammenwirkt, um die in wenigstens einer Spalte (C1, C3) von mehreren aufeinanderfolgenden Spalten erzeugten Ladungen zurückzuhalten.

5. Lichtempfindliche Vorrichtung nach Anspruch 4, dadurch gekennzeichnet, daß zwei Leseregister (RL1, RL2) vorhanden sind und daß die Multiplexelektrode (EM) die Ladungen von jeder zweiten Spalte zurückhält.

6. Lichtempfindliche Vorrichtung nach einem der Ansprüche 4 oder 5, wobei die verschiedenen Elektroden (E1 bis E4, E4S, EM) von einem Halbleitersubstrat (4) getragen werden, dadurch gekennzeichnet, daß die Endelektroden (E4S) zwischen der Multiplexelektrode (EM) und dem Substrat (4) nur in den Spalten (C2, C4) angeordnet sind, deren Ladungen nicht mittels der Multiplexelektrode (EM) zurückgehalten werden.

7. Lichtempfindliche Vorrichtung nach einem der Ansprüche 4 bis 6, dadurch gekennzeichnet, daß die Endelektroden (E4S) durch Spannungssignale (ST4S) gesteuert werden, die zwischen einem hohen und einem niedrigen Wert variieren können, wobei der Wert des niedrigen Niveaus so ist, daß er im Zusammenwirken mit der Multiplexelektrode ermöglicht, unter den Endelektroden der Spalten (C1, C3), deren Ladungen zurückgehalten werden, eine Potentialsenke zu bilden.

## Claims

1. Photosensitive charge-coupled device, comprising a matrix arrangement of elementary photosensitive zones or pixels (P1 to P6), at least two distinct read registers (RL1, RL2), the photosensitive charges coming from certain columns (C1, C3) being loaded into the first register (RL1) while the charges coming from other columns (C2, C4) go through the first register (RL1) so as to be loaded into the second (RL2), characterized in that the read registers comprise stages laid out at a pitch equal to n times the pitch of the columns, n being the number of read registers, in that each stage of the read registers includes at least two sub-stages following one another along a direction of transfer perpendicular to the columns, the first and the second sub-stages of the first read register being opposite respectively the first and second sub-stages of the second read register, the charges transferred into the second register going through the first sub-stages of the first register, and the potentials applied to the electrodes of the first register during loading being different from the potentials applied to the electrodes of the second register at the same time.

2. Photosensitive device according to Claim 1, characterized in that transfer means are provided so as:
- initially to inhibit the loading into the first register (RL1) while at the same time enabling the loading of the second register (RL2) through the first one, and
- the subsequently to load the first register (RL1).

3. Photosensitive device according to any of the above claims characterized in that the read registers are of the type working in two-phase mode.

4. Photosensitive device according to any of the above claims, each pixel (P1 to P16) comprising at least two electrodes (E1, E2, E3, E4) following each other in the direction of the columns (C1 to C4) along a first transfer direction (D1), in each column (C1 to C4) the last electrode (E4S) of the last pixel constituting an electrode called a final electrode, at least one passage electrode (EP1) being positioned between the photosensitive zone (ZP) and the read registers (RL1, RL2) in order to prohibit or enable charge transfers towards the latter, characterized in that at least one so-called multiplexing electrode (EM) is positioned between the pixels (P1 to P16) and the passage electrode (EP1), the multiplexing electrode (EM) cooperating with the passage electrode (EP1) and the output electrodes (E4S) to retain the charges produced in at least one column (C1, C3) on several consecutive columns.

5. Photosensitive device according to Claim 4, characterized in that the read registers (RL1, RL2) are two in number and in that the multiplexing electrode (EM) retains the charges of one in every two columns.

6. Photosensitive device according to either of Claims 4 or 5, the different electrodes (E1 to E4; E4S, EM) being borne by a semiconductor substrate (4), characterized in that the final electrodes (E4S) are interposed between the multiplexing electrode (EM) and the substrate (4) solely in the columns (C2, C4) whose charges are not retained by means of the multiplexing electrode (EM).

7. Photosensitive device according to any of Claims 4, 5 or 6 characterized in that, with the final electrodes (E4S) being controlled by voltage signals (ST4S) that can vary between a high level and a low level, the value of the low level is such that it enables the construction, in cooperation with the multiplexing electrode, of a potential well beneath the final electrodes of the columns (C1, C3) whose charges are retained.
